**Europäisches Patentamt**

**European Patent Office**

**Office européen des brevets**

(19)

(11)  **EP 1 610 140 A1**

(12)  **EUROPEAN PATENT APPLICATION**
published in accordance with Art. 158(3) EPC

(43) Date of publication:
**28.12.2005 Bulletin 2005/52**

(51) Int Cl.⁷: **G01R 31/36**

(21) Application number: **04724813.3**

(86) International application number:
**PCT/JP2004/004651**

(22) Date of filing: **31.03.2004**

(87) International publication number:
**WO 2004/088343 (14.10.2004 Gazette 2004/42)**

(84) Designated Contracting States:
**AT BE BG CH CY CZ DE DK EE ES FI FR GB GR
HU IE IT LI LU MC NL PL PT RO SE SI SK TR**
Designated Extension States:
**AL LT LV MK**

(30) Priority: **31.03.2003 JP 2003097466**

(71) Applicant: **YAZAKI CORPORATION
Minato-ku Tokyo 108-8333 (JP)**

(72) Inventors:
 • **ARAI, Youichi, c/o Yazaki Corporation
   Susono-shi, Shizuoka 410-1194 (JP)**
 • **AMANO, Kenichi, c/o Yuasa Corporation
   Takatsuki-shi, Osaka 569-1115 (JP)**

(74) Representative: **Viering, Jentschura & Partner
   Steinsdorfstrasse 6
   80538 München (DE)**

(54) **APPARATUS AND METHOD FOR DETECTING FULLY CHARGED CONDITION, APPARATUS AND METHOD FOR DETECTING CHARGED CONDITION, AND APPARATUS AND METHOD FOR DETERMINING DEGREE OF DEGRADATION**

(57)  A CPU 23a detects a charging efficiency which is a ratio of an electrical quantity to be stored in a battery 13 as electromotive force to an electrical quantity flowed into the battery 13 at any time point from a start of charging to an end of charging of the battery 13 on the basis of a charging current and charging voltage obtained by using a current sensor 15 and voltage sensor 17. Then, a fully charged state of the battery 13 is detected when the detected charging efficiency can be regarded as zero.

FIG. 1

**Description**

[TECHNICAL FIELD]

The present invention relates to a fully charged state detecting device and method, a state-of-charge detecting device and method, and a degradation degree detecting device and method.

[BACKGROUND ART]

When a battery is kept being charged beyond its fully charged state, an electrical quantity flowed into the battery is consumed by decomposition of water $H_2O$ in an electrolyte of the battery, resulting in that an amount of the electrolyte is reduced, thereby promoting the degradation of the battery. Accordingly, so far, for example, a charge of a battery is carried out with a constant current or constant voltage, and when an electrical quantity stored in the battery exceeds a predetermined value, a charge is carried out with a very small current for a predetermined period of time. Then, the charge is finished at a time point when the charge with the very small current for the predetermined period of time is completed, assuming that said time point is a time point when the battery reaches its fully charged state.

As a different idea, it is proposed to judge that a battery is in its fully charged state when a condition in which a difference between a real voltage of the battery and a command voltage thereof is less than a predetermined value lasts a fixed time period $T_{20}$ and a condition in which a charging current I is less than a predetermined threshold value $I_0$ lasts a fixed time period $T_{10}$ (for example, Japanese Patent Application Laid-Open No. 2002-345162).

Generally, a battery gradually degrades during its repeated charge and discharge processes, thereby causing gradual degradation in its capacity at a fully charged state thereof. Therefore, when a battery degrades, the battery reaches its fully charged state at a time point when a time period of charging with a very small current does not reach a predetermined time period or before a time point when a charging current I becomes less than a predetermined threshold value $I_0$, resulting in that a fully charged state of the battery cannot be correctly detected.

It is therefore an objective of the present invention to solve the above problems and to provide a fully charged state detecting device and method, a state-of-charge detecting device and method by using the fully charged state detecting device and method, and a degradation degree detecting device and method by using the fully charged state detecting device and method, by which a fully charged state of a battery can be correctly detected even if a capacity of the fully charged state of the battery is changed.

[DISCLOSURE OF THE INVENTION]

The present invention is a fully charged state detecting device including charging efficiency detecting means for detecting a charging efficiency which indicates a ratio of an electrical quantity to be stored in a battery as electromotive force to an electrical quantity flowed into the battery at any time point from a start of charging to an end of charging of the battery, wherein a fully charged state of the battery is detected when the detected charging efficiency can be regarded as zero.

[BRIEF DESCRIPTION OF THE DRAWINGS]

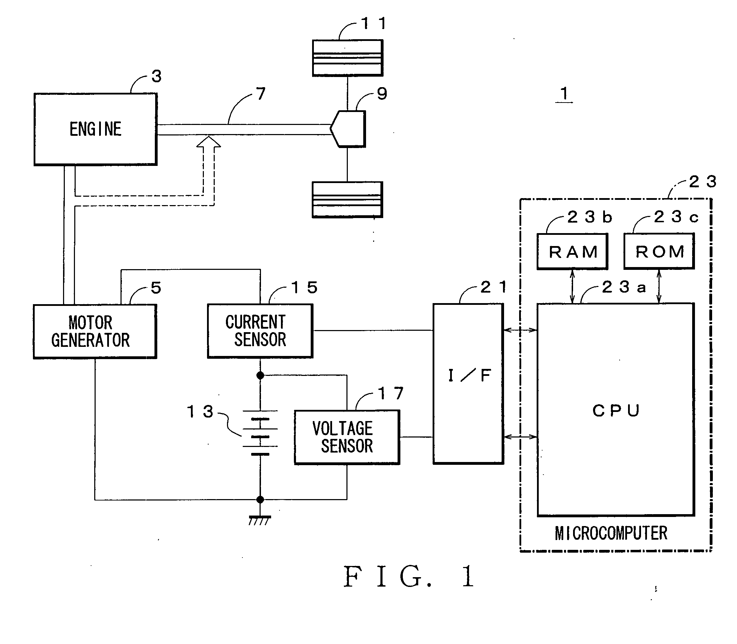

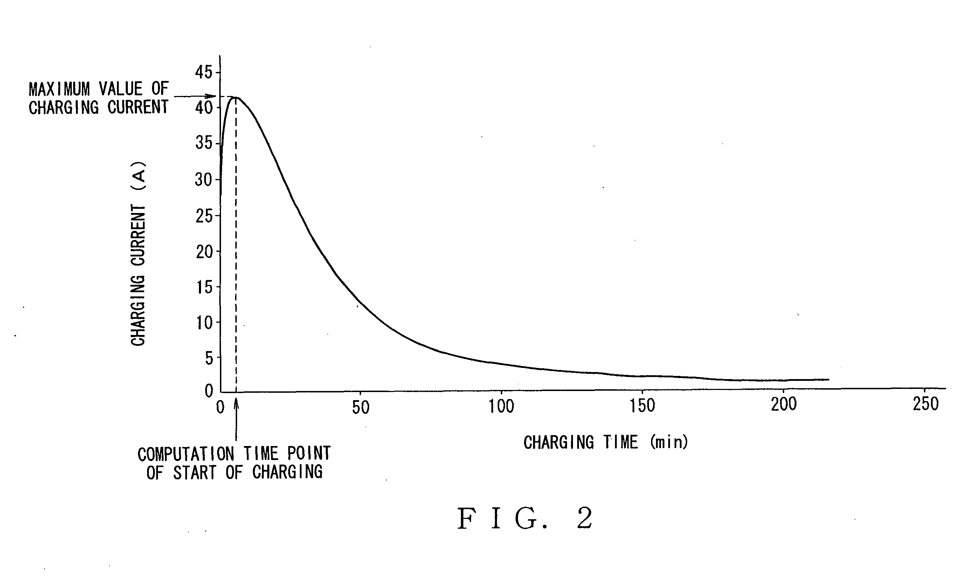

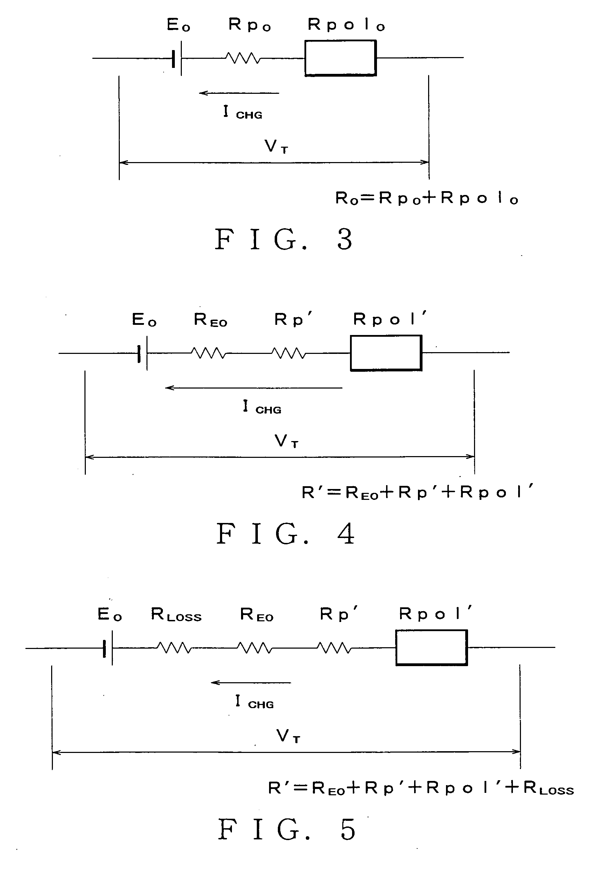

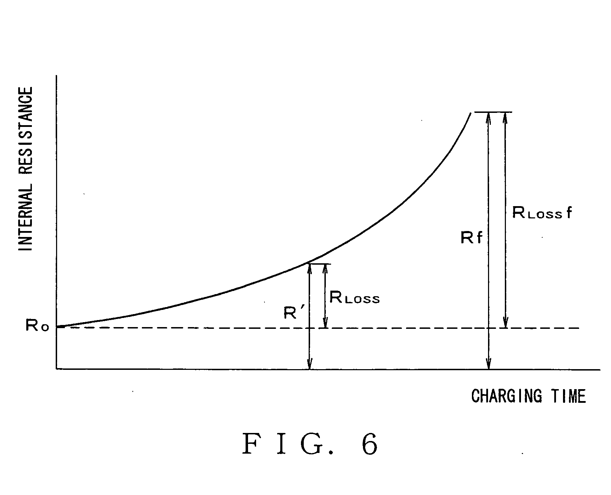

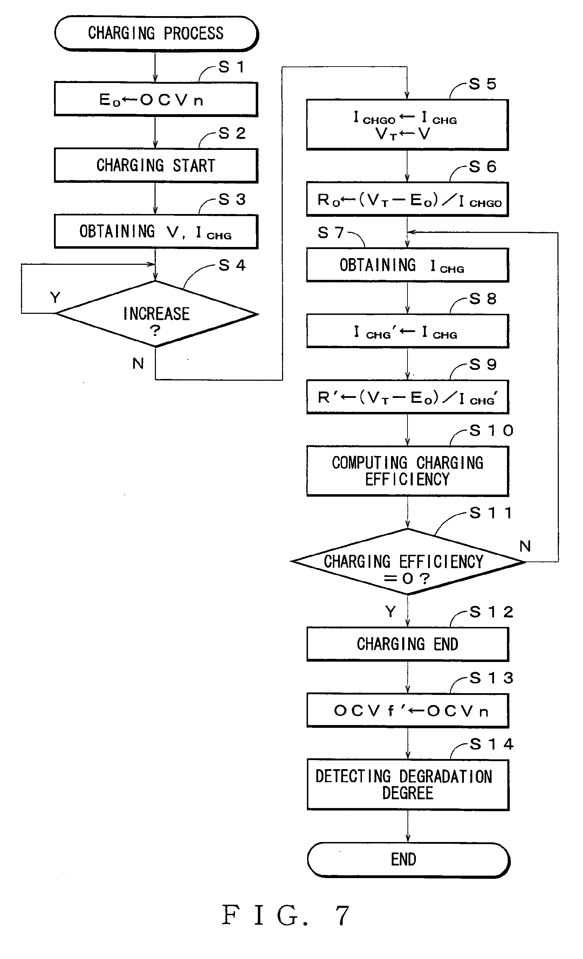

Figure 1 is a block diagram illustrating a preferred embodiment of a battery control device, into which a fully charged state detecting device (in which a fully charged state detecting method according to the present invention is applied), a state-of-charge detecting device (in which a state-of-charge detecting method according to the present invention is applied), and a degradation degree detecting device (in which a degradation degree detecting method according to the present invention is applied) are assembled. Figure 2 is a graph illustrating a relation between a charging time and charging current. Figure 3 is an equivalent circuit of a battery 13 at a time point when a charging is started. Figure 4 is an equivalent circuit of a battery 13 during a charging (charging efficiency = 100%). Figure 5 is an equivalent circuit of a battery 13 during a charging (charging efficiency < 100%). Figure 6 is a graph illustrating a relation between a charging time and internal resistance of a battery 13. Figure 7 is a flow chart illustrating a processing order of a CPU 23a of the battery control device shown in Fig. 1.

[BEST MODE FOR CARRING OUT THE INVENTION]

In the following, the preferred embodiments of the present invention will be explained with reference to the attached drawings. Figure 1 is a block diagram illustrating a preferred embodiment of a battery control device, into which a fully charged state detecting device (in which a fully charged state detecting method according to the present invention is applied), a state-of-charge detecting device (in which a state-of-charge detecting method according to the present invention is applied), and a degradation degree detecting device (in which a degradation degree detecting method according to the present invention is applied) are assembled. As shown in Fig. 1, a battery control device 1 according to the preferred embodiment of the present invention is mounted on a hybrid vehicle that includes an engine 3 and motor generator 5.

Normally, only an output of the engine 3 is transmitted from a drive shaft 7 to wheels 11 via differential case 9 so as to drive the vehicle, on the other hand, upon traveling with high load, the motor generator 5 functions as a motor by an electric power from a battery 13 so that an output of the motor generator 5 together with the output of the engine 3 is transmitted from the drive shaft 7 to the wheels 11, thereby an assistant driving is carried out.

In this hybrid vehicle, the motor generator 5 functions as a generator upon the decelerating or braking so as to convert the kinetic energy to the electric energy, thereby the battery 13 is charged. The battery 13 is mounted on the hybrid vehicle so as to supply the electric power to various loads.

Further, the motor generator 5 is used as a starter motor, which forcibly rotates a flywheel of the engine 3, upon the start of the engine 3 in response to the switching on of a starter switch (not shown in the figure).

The battery control device 1 according to the preferred embodiment includes: a current sensor 15 for detecting a discharging current of the battery 13 with respect to a motor for an assistant driving and motor generator 5 that functions as a starter motor and a charging current to the battery 13 flowing from the motor generator 5 that functions as a generator; and a voltage sensor 17 having an infinite resistance connected in parallel to the battery 13 for detecting a terminal voltage of the battery 13.

The current sensor 15 and voltage sensor 17 are arranged on a circuit which is closed in an on-switch condition of an ignition switch.

The battery control device 1 according to the preferred embodiment further includes a microcomputer 23, into which outputs of the current sensor 15 and voltage sensor 17 are stored after their analog/digital (hereinafter, A/D) conversion performed in an interface circuit (hereinafter, I/F) 21.

The microcomputer 23 includes a CPU 23a, RAM 23b, and ROM 23c. The CPU 23a is connected to the I/F 21 besides the RAM 23b and ROM 23c. A signal for indicating a switching-on or switching-off condition of an ignition switch (not shown in the figure) is inputted to the CPU 23a.

The RAM 23b has a data area for storing various data and a work area for use in various processings. Control programs for making the CPU 23a implement various processings are stored in the ROM 23c. A sum of a pure resistance $R_0f$ and a polarization resistance component Rpolf (= activation polarization + concentration polarization) of a battery 13 upon its mounting on a hybrid vehicle, that is, upon its brand-new condition is in advance stored as a characteristic fully charged resistance value in the ROM 23c. That is, a value of an internal resistance Rf (= $R_0f$ + Rpolf) is in advance stored as a characteristic fully charged resistance value in the ROM 23c.

On a switching-off condition of the ignition switch, the microcomputer 23 is in a sleep mode in which only a necessary minimum processing is carried out with a dark current supplied from the battery 13, while on a switching-on condition of the ignition switch, the microcomputer 23 wakes up so as to be in a normal active mode.

In the following, a basic idea for a charging efficiency of the battery 13 and a method how to estimate the charging efficiency of the battery 13 during charging will be explained.

First, when the battery 13 is constant voltage-charged with a set charging voltage value $V_T$, if an electrically insulating passive membrane is formed on a surface of an electrode of the battery 13 while the former charging or discharging has not been carried out, the passive membrane is gradually broken to be eliminated shortly by being applied the set charging voltage value $V_T$ to the battery 13 immediately after a start of the charging.

In this case, even if the charging of the battery 13 is started, a charging current $I_{CHG}$ having a value according to the set charging voltage value $V_T$ does not start to flow immediately. Instead, as shown in Fig. 2, as the electric conduction property of an electrode is gradually recovered due to the progress of the breaking of the passive membrane, the charging current $I_{CHG}$ of the battery 13 gradually increases to become a value according to the set charging voltage value $V_T$.

Then, in a stage while the charging current $I_{CHG}$ of the battery 13 is gradually increasing to become a value according to the set charging voltage value $V_T$, it can be regarded that there is no decline in the charging efficiency. Therefore, for a time period while the value of the charging current $I_{CHG}$ is reaching a value according to the set charging voltage value $V_T$, it can be regarded that the battery 13 is charged with the charging efficiency = 100% having no connection with a progress of the charging time.

At a time point when the value of the charging current $I_{CHG}$ reaches a value according to the set charging voltage value $V_T$, the passive membrane is completely broken, so that a resistance component due to the passive membrane disappears. Therefore, the value of the charging current $I_{CHG}$ of the battery 13 on a condition of the constant voltage-charging with a set charging voltage value $V_T$ depends only on an internal electromotive force $E_0$ of the battery 13 and internal resistance R of the battery 13.

In a time period while the value of the charging current $I_{CHG}$ of the battery 13 is reaching a maximum value according to the set charging voltage value $V_T$ due to the progress of the breaking of the passive membrane, the

internal electromotive force $E_0$ of the battery 13 increases. However, its amount of increase $\Delta E_0$ is very small compared to the internal electromotive force $E_0$ itself. Therefore, it is considered that a resistance component of the battery 13 at a time point when the vale of the charging current $I_{CHG}$ reaches the maximum value substantially does not include a resistance component corresponding to the amount of increase $\Delta E_0$.

Here, a time point of a start of charging of the battery 13 is set to be a time point when a constant voltage with the set charging voltage value $V_T$ is applied to the battery 13, wherein an insulating passive membrane is not formed on a surface of an electrode of the battery 13, or a time point when an insulating passive membrane formed on a surface of an electrode of the battery 13 is completely broken by being applied a constant voltage with the set charging voltage value $V_T$ so that the value of the charging current $I_{CHG}$ of the battery 13 reaches a maximum value according to the set charging voltage value $V_T$.

As shown in Fig. 3, the battery 13 at a time point of a start of charging can be expressed by an equivalent circuit in which the internal resistance $R_0$ of the battery 13 and an electromotive force $E_0$ are connected in series. The internal resistance $R_0$ at a time point of a start of charging can be expressed by the following expression:

$$R_0 = Rp_0 + Rpol_0,$$

wherein $Rp_0$ indicates a pure resistance of the battery 13 at a time point of a start of charging and $Rpol_0$ indicates a polarization resistance component at a time point of a start of charging.

In the battery 13 during charging with the set charging voltage value $V_T$, the electromotive force increases as follows:

$$\text{electromotive force } E_0 \rightarrow E_0 + \Delta E_0.$$

On the other hand, the pure resistance and polarization resistance component decrease because the electromotive force of the battery 13 increases and a voltage difference between the set charging voltage value $V_T$ and the electromotive force of the battery 13 decreases as follows:

$$\text{pure resistance } Rp_0 \rightarrow Rp' \ (Rp' < Rp_0), \text{ and}$$

$$\text{polarization resistance component } Rpol_0 \rightarrow Rpol' \ (Rpol' < Rpol_0),$$

wherein $Rp'$ indicates a pure resistance of a battery 13 during charging and $Rpol'$ indicates a polarization resistance component during charging.

Considering the increment $\Delta E_0$ of the internal electromotive force $E_0$ of the battery 13 as a change portion $R_{E0}$ in resistance of the electromotive force increment, as shown with an equivalent circuit in Fig. 4, the internal resistance $R'$ of the battery 13 during charging is expressed as follows:

$$R' = R_{E0} + Rp' + Rpol'.$$

During charging of the battery 13, if an electrical quantity flowed into the battery 13 is equal to an electrical quantity stored as electromotive force in the battery 13, that is, if a charging efficiency is 100% (i.e. ideal value), the following expression comes into existence:

$$R_0 = R'.$$

That is, if the charging efficiency is 100%, the internal resistance $R'$ is always constant. This is because the pure resistance and polarization resistance component decrease in response to the increment (= $R_{E0}$) in the resistance corresponding to the electromotive force increment.

On the other hand, if a charging efficiency is less than 100%, as shown with an equivalent circuit in Fig. 5, the internal resistance $R'$ of the battery 13 has a value to which a loss resistance $R_{LOSS}$ corresponding to an electrical quantity that fails to contribute for the electromotive force increment due to electrolysis of water is added. Therefore, the internal resistance $R'$ during charging is expressed as follows:

$$R' = R_{E0} + Rp' + Rpol' + R_{LOSS}.$$

Accordingly, the $R_{LOSS}$ can be computed by subtracting the internal resistance $R_0$ at a time point of a start of charging from the internal resistance R' during charging as follows:

$$R_{LOSS} = R' - R_0.$$

That is, as shown in Fig. 6, the internal resistance of the battery 13 increases as approaching its fully charged state and the increment from the internal resistance $R_0$ at a time point of a start of charging corresponds to the loss resistance $R_{LOSS}$.

If a charging current corresponding to an electrical quantity actually flowing into the battery 13 is set to be $I_{CHG}$ (measured), an effective current corresponding to an electrical quantity actually stored as the electromotive force in the battery 13 is set to be $I_{CHG}$ (effective), and a difference between $I_{CHG}$ (effective) and $I_{CHG}$ (measured), which corresponds to an electrical quantity that is not stored as the electromotive force in the battery 13 but consumed for electrolysis of water, is set to be $I_{LOSS}$, the following expression comes into existence:

$$I_{CHG} \text{ (measured)} = I_{CHG} \text{ (effective)} + I_{LOSS}.$$

Then, the charging efficiency of the battery 13 can be computed by using the following expression:

$$\text{charging efficiency} = [I_{CHG} \text{ (effective)}/ I_{CHG} \text{ (measured)}] \times 100\%.$$

Since $I_{CHG}$ (measured) is a value of charging current actually flowing into the battery 13, $I_{CHG}$ (measured) can be measured by collecting outputs from the current sensor 15 through the I/F21. On the other hand, $I_{CHG}$ (effective) and $I_{LOSS}$ cannot be actually measured. Therefore, the above expression,

$$\text{charging efficiency} = [I_{CHG} \text{ (effective)}/ I_{CHG} \text{ (measured)}] \times 100\%$$

must be expressed by using other factors which can be measured or computed.

In a fully charged state of the battery 13, since the amount of lead sulfate PbSO4 is very small, most of the $I_{CHG}$ (measured) is consumed for electrolysis of water and so on and therefore the electrical quantity is not stored as the electromotive force in the battery 13.

The loss resistance $R_{LOSS}$ out of the internal resistance $R' = R_{E0} + Rp' + Rpol' + R_{LOSS}$ of the battery 13 during charging can be regarded to correspond to a value of an electrical quantity, which is not stored as the electromotive force in the battery 13, out of an electrical quantity flowing into the battery 13 at a time point. Therefore, a value indicating a decline ratio of the charging efficiency of the battery 13 can be computed by dividing a value of loss resistance $R_{LOSS}$ at any time point during charging by loss resistance $R_{LOSS}f$ of the battery 13 in its state of charging efficiency = 0, that is, in its fully charged state.

As described above, the loss resistance $R_{LOSS}$ at any time point during charging can be computed by the following expression:

$$R_{LOSS} = R' - R_0.$$

On the other hand, there is a relation as shown in Fig. 6 between the internal resistance Rf in a characteristic fully charged state of the battery 13 and the loss resistance $R_{LOSS}f$ in the fully charged state. That is,

$$Rf = R_{LOSS}f + R_0.$$

Therefore, the loss resistance $R_{LOSS}f$ in the fully charged state can be computed by the following expression:

$$R_{LOSS}f = Rf - R_0.$$

Accordingly, a value obtained by dividing a value of loss resistance $R_{LOSS}$ at any time point during charging by the loss resistance $R_{LOSS}f$ of the battery 13 in its state of charging efficiency = 0, that is, in its fully charged state can be computed by the following expression:

$$(R' - R_0)/(Rf - R_0).$$

Therefore, a value indicating a decline ratio of the charging efficiency of the battery 13 at any time point during charging can be computed by the following expression:

$$(R' - R_0)/(Rf - R_0).$$

Then, the charging efficiency of the battery 13 at any time point during charging can be computed by the following expression:

$$[1- (R' - R_0)/(Rf - R_0)] \times 100\%.$$

The above are a basic idea for a charging efficiency of the battery 13 and a method how to estimate the charging efficiency of the battery 13 during charging.

In the following, a method how to estimate the internal resistance R' of the battery 13 during charging action will be explained. This method is necessary for computing the charging efficiency of the battery 13.

Supposing that the passive membrane is not formed on an electrode surface of the battery 13, a state of the battery 13 can be expressed by an expression, in which a value obtained by subtracting the internal electromotive force $E_0$ of the battery 13 before a start of charging from the set charging voltage value $V_T$ that is a terminal voltage V of the battery 13 is equal to a value obtained by multiplying the internal resistance R' of the battery 13 by the charging current $I_{CHG}$. Such an expression is as follows:

$$V_T - E_0 = R' \times I_{CHG}.$$

Therefore, the internal resistance R' of the battery 13 during charging can be computed by the following expression:

$$R' = (V_T - E_0)/ I_{CHG}.$$

In this connection, the internal electromotive force $E_0$ of the battery 13 before a start of charging is equal to a value of an open circuit voltage OCV (= an open terminal voltage V of the battery 13 in an equilibrium state) at the time point. Therefore, a value of an open circuit voltage OCV is computed in order to obtain such an internal electromotive force $E_0$.

In the following, a concrete method how to compute an open circuit voltage OCV of the battery 13 before a start of charging will be explained. When the battery 13 is in an equilibrium state and in a state in which the polarization disappears, an open circuit voltage of the battery 13 measured at that time is obtained as an OCV.

On the other hand, when the battery 13 is not in an equilibrium state and not in a state in which the polarization disappears, for example, the OCV estimated on the basis of values of the terminal voltage V collected by using the voltage sensor 17 after former charging or discharging is set to be an OCV before a start of charging.

In the following, a processing that the CPU 23a performs in accordance with a control program stored in the ROM 23c will be explained with reference to a flow chart shown in Fig. 7.

When the microcomputer 23 starts being supplied an electric power from the battery 13 so as to start the program, the CPU 23a starts a charging process (explained later on) when the battery 13 can be charged upon decelerating or braking.

In the charging process, first, the CPU 23a computes an open circuit voltage OCV at a present time point by measurement or estimation and stores thus computed open circuit voltage OCV in the RAM 23b as an internal elec-

tromotive force $E_0$ of the battery 13 at a time point of a start of charging (step S1), then starts the charging of the battery 13 by making the motor generator 5 function as a generator (step S2).

Then, the CPU 23a obtains the charging current $I_{CHG}$ that is an output from the current sensor 15 and the charging voltage V that is an output from the voltage sensor 17 through the I/F21(step S3). Then, the CPU 23a judges whether or not the obtained charging current $I_{CHG}$ increases compared to the charging current $I_{CHG}$ obtained at the last time (step S4).

If it is increased (Y at step S4), the CPU 23a judges that there is a resistance component due to the passive membrane and returns to step S3. On the other hand, if it is not increased (N at step S4), the CPU 23a judges that there is no resistance component due to the passive membrane and sets the charging current $I_{CHG}$ obtained at step S3 to be the charging current $I_{CHG0}$ at a time point of a start of charging, sets the charging voltage V to be the set charging voltage value $V_T$, and stores them in the RAM 23b (step S5).

Then, the CPU 23a computes the internal resistance $R_0$ of the battery 13 at a computation time point of a start of charging by using the following expression (step S6):

$$R_0 = (V_T - E_0)/I_{CHG0}.$$

Then, the CPU 23a again obtains the charging current $I_{CHG}$ that is an output from the current sensor 15 through the I/F21 (step S7), sets thus obtained charging current $I_{CHG}$ to be the charging current $I_{CHG}'$ at the present time point, and stores it in the RAM 23b (step S8). Then, the CPU 23a computes the internal resistance R' of the battery 13 at the present time point by using the following expression (step S9):

$$R' = (V_T - E_0)/ I_{CHG}'.$$

Then, the CPU 23a functions as the charging efficiency detecting means so that by using a value of the internal resistance R' computed at step S9, a value of the internal resistance Rf in a characteristic fully charged state of the battery 13 stored in the ROM 23c and a value of the internal resistance $R_0$ stored in the RAM 23b, the CPU 23a computes the charging efficiency of the battery 13 at this time point by using the following expression (step S10):

$$[1 - (R' - R_0)/(Rf - R_0)] \times 100\%.$$

Then, the CPU 23a judges whether or not the computed charging efficiency can be regarded as 0% (step S11). If the charging efficiency cannot be regarded as 0% (N at step S11), the CPU 23a returns to step S7. On the other hand, if the charging efficiency can be regarded as 0% (Y at step S11), the CPU 23a judges that the battery 13 is in a fully charged state and finishes the charging of the battery 13 (step S12).

When the battery is in a fully charged state, all of the electrical quantity flowing into the battery is consumed for electrolysis of water, rendering the charging efficiency to be zero. Accordingly, when the charging efficiency becomes zero, it is detected (judged) that the battery is in a fully charged state. As a result, the fully charged state can be detected without being influenced by temperature or degradation of the battery and a change in the capacity of the fully charged state due to an individual characteristic of the battery.

Then, the CPU 23a computes an open circuit voltage OCVn at this time point and stores the computed open circuit voltage OCVn in the RAM 23b as an open circuit voltage OCVf' in the present fully charged state (step S13). Further, the CPU 23a acts as the degradation degree detecting means and computes the degradation degree of the battery 13 by using the following expression(step S 14):

$$(OCVf' - OCVe)/(OCVf - OCVe),$$

and then finishes the charging process. Here, OCVe is an open circuit voltage of the battery in its state of an end of discharging and OCVf is an open circuit voltage of a brand-new battery in its fully charged state.

An electrical quantity stored in the battery 13 is in proportion to an open circuit voltage of the battery 13. Therefore, by using the above expression, a relative value of an electrical quantity stored in the battery 13 at a time point when the fully charged state is detected on the basis of the charging efficiency can be computed as a degradation degree, wherein the electrical quantity stored in a brand-new battery in its fully charged state is set to be 100%, while the electrical quantity stored in the battery 13 at an end of discharging is set to be 0%.

Further, the CPU 23a also acts as the state-of-charge detecting means and performs the detection of the state of charge, which indicates an electrical quantity stored in the battery 13, by using the OCVf' stored at step S 14.

In detail, when the CPU 23a judges that it is necessary to detect the state-of-charge, the CPU 23a computes the open circuit voltage OCVn at that time point by the measurement or estimation as described above. Then, the CPU 23a computes the state of charge of the battery 13 by the following expression:

$$(OCVn - OCVe)/(OCVf' - OCVe).$$

By using the above expression, a relative value of an electrical quantity stored in the battery 13 at any time point can be detected as the state of charge, wherein the electrical quantity stored in the battery 13 at a time point when the charging efficiency becomes zero and the fully charged state is detected is set to be 100%, while the electrical quantity stored in the battery 13 at an end of discharging is set to be 0%. Therefore, the state-of-charge can be detected taking temperature or degradation of the battery and a change in the capacity of the fully charged state due to an individual characteristic of the battery into consideration.

In the preferred embodiment described above, the loss resistance $R_{LOSS}f$ of the battery 13 in the fully charged state is computed by $R_{LOSS}f = Rf - R_0$, and the charging efficiency is computed by the following expression:

$$[1 - (R' - R_0)/(Rf - R_0)] \times 100\%.$$

However, a value of the internal resistance $R_{E0} + Rp' + Rpol'$ of the battery 13 is negligibly small compared to a value of the loss resistance $R_{LOSS}f$ of the battery 13 at a time point when the charging efficiency = 0, that is, at a time point of fully charged state. That is, the following relation comes into existence:

$$R_{LOSS}f >> R_{E0} + Rp' + Rpol' .$$

Therefore, as for the internal resistance Rf in a characteristic fully charged state of the battery 13, the following relation comes into existence:

$$Rf = R_{E0} + Rp' + Rpol' + R_{LOSS}f \cong R_{LOSS}f.$$

Therefore, a value of the loss resistance $R_{LOSS}f$ of the battery 13 in a fully charged state of the battery 13 may be replaced by a value of the internal resistance Rf in a characteristic fully charged state of the battery 13 stored in the ROM 23c, then the charging efficiency may be computed by the following expression:

$$[1 - (R' - R_0)/Rf] \times 100\%.$$

The aforementioned preferred embodiments are described to aid in understanding the present invention and variations may be made by one skilled in the art without departing from the spirit and scope of the present invention. For example, the method of detecting a degradation degree may be modified or applied without departing from the spirit and scope of the present invention.

[INDUSTRIAL APPLICABILITY]

In the invention defined in claim 1, it is noted that when a battery is in a fully charged state thereof, all of electrical quantity further flowing into the battery is not used for electromotive force but used for electrolysis of water, so that the charging efficiency becomes zero. The charging efficiency detecting means detects a charging efficiency which is a ratio of an electrical quantity to be stored in a battery as electromotive force to an electrical quantity flowed into the battery at any time point from a start of charging to an end of charging of the battery. When the detected charging efficiency can be regarded as zero, a fully charged state of the battery is detected. Since the fully charged state is detected by using the charging efficiency of the battery, therefore the fully charged state can be detected without being influenced by temperature or degradation of the battery and a change in the capacity of the fully charged state due to an individual characteristic of the battery. Accordingly, the fully charged state can be correctly detected.

According to the invention defined in claim 2, the charging efficiency detecting means detects the charging efficiency of the battery on the basis of a ratio of a difference between an internal resistance value at a time point when a charging of the battery is started and an internal resistance value at any time point from a start of charging to an end of charging of the battery to an internal resistance value in a fully charged state of the battery. Therefore, by using the internal resistance which can be measured during charging, the charging efficiency of the battery at any time point can be correctly detected. Accordingly, the fully charged state can be more correctly detected.

According to the invention defined in claim 3, the state-of-charge detecting means detects a relative value of an electrical quantity stored in the battery at any time point as the state of charge, wherein the electrical quantity stored in the battery at a time point when the fully charged state detecting device according to claim 1 detects the fully charged state is set to be 100%, while the electrical quantity stored in the battery at an end of discharging is set to be 0%. Since, the state-of-charge is detected by setting the electrical quantity stored in the battery in the fully charged state that is detected on the basis of the charging efficiency of the battery to be 100%, therefore the state-of-charge can be detected taking temperature or degradation of the battery and a change in the capacity of the fully charged state due to an individual characteristic of the battery into consideration. Accordingly, the state of charge can be correctly detected.

In the invention defined in claim 4, it is noted that a capacity of the fully charged state is changed due to the degradation of the battery. The degradation degree detecting means detects a relative value of an electrical quantity stored in the battery at a time point when the fully charged state detecting device according to claim 1 or 2 detects the fully charged state as a degradation degree, wherein the electrical quantity stored in a brand-new battery in its fully charged state is set to be 100%, while the electrical quantity stored in the battery at an end of discharging is set to be 0%. Therefore, by detecting the degradation degree on the basis of the electrical quantity stored in the battery upon a fully charged state that is detected on the basis of the charging efficiency of the battery, the degradation degree of the battery can be correctly detected.

In the invention defined in claim 5, it is noted that when a battery is in a fully charged state thereof, all of electrical quantity further flowing into the battery is not used for electromotive force but used for electrolysis of water, so that the charging efficiency becomes zero. The fully charged state of the battery is detected when the charging efficiency, which is a ratio of an electrical quantity to be stored in a battery as electromotive force to an electrical quantity flowed into the battery at any time point from a start of charging to an end of charging of the battery, can be regarded as zero. Since the fully charged state is detected by using the charging efficiency of the battery, therefore the fully charged state can be detected without being influenced by temperature or degradation of the battery and a change in the capacity of the fully charged state due to an individual characteristic of the battery. Accordingly, the fully charged state can be correctly detected.

According to the invention defined in claim 6, a relative value of an electrical quantity stored in the battery at any time point is detected as the state of charge, wherein the electrical quantity stored in the battery at a time point when the fully charged state is detected by using the fully charged state detecting method according to claim 5 is set to be 100%, while the electrical quantity stored in the battery at an end of discharging is set to be 0%. Since, the state-of-charge is detected by setting the electrical quantity stored in the battery in the fully charged state that is detected on the basis of the charging efficiency of the battery to be 100%, therefore the state-of-charge can be detected taking temperature or degradation of the battery and a change in the capacity of the fully charged state due to an individual characteristic of the battery into consideration. Accordingly, the state of charge can be correctly detected.

In the invention defined in claim 7, it is noted that a capacity of the fully charged state is changed due to the degradation of the battery. A relative value of an electrical quantity stored in the battery at a time point when the fully charged state is detected by using the fully charged state detecting method according to claim 5 is detected as a degradation degree, wherein the electrical quantity stored in a brand-new battery in its fully charged state is set to be 100%, while the electrical quantity stored in the battery at an end of discharging is set to be 0%. Therefore, by detecting the degradation degree on the basis of the electrical quantity stored in the battery upon a fully charged state that is detected on the basis of the charging efficiency of the battery, the degradation degree of the battery can be correctly detected.

**Claims**

1.   A fully charged state detecting device comprising charging efficiency detecting means for detecting a charging efficiency which indicates a ratio of an electrical quantity to be stored in a battery as electromotive force to an electrical quantity flowed into the battery at any time point from a start of charging to an end of charging of the battery, wherein a fully charged state of the battery is detected when the detected charging efficiency can be regarded as zero.

2.   The fully charged state detecting device according to claim 1, wherein the charging efficiency detecting means detects the charging efficiency of the battery on the basis of a ratio of a difference between an internal resistance value at a time point when a charging of the battery is started and an internal resistance value at any time point from a start of charging to an end of charging of the battery to an internal resistance value in a fully charged state of the battery.

3. A state-of-charge detecting device for estimating a state of charge indicating an electrical quantity stored in a battery comprising state-of-charge detecting means for detecting a relative value of an electrical quantity stored in the battery at any time point as the state of charge, wherein the electrical quantity stored in the battery at a time point when the fully charged state detecting device according to claim 1 or 2 detects the fully charged state is set to be 100%, while the electrical quantity stored in the battery at an end of discharging is set to be 0%.

4. A degradation degree detecting device for estimating a degradation degree of a battery comprising degradation degree detecting means for detecting a relative value of an electrical quantity stored in the battery at a time point when the fully charged state detecting device according to claim 1 or 2 detects the fully charged state as a degradation degree, wherein the electrical quantity stored in a brand-new battery in its fully charged state is set to be 100%, while the electrical quantity stored in the battery at an end of discharging is set to be 0%.

5. A fully charged state detecting method, **characterized in that** a fully charged state of a battery is detected when a charging efficiency, which is a ratio of an electrical quantity to be stored in a battery as electromotive force to an electrical quantity flowed into the battery at any time point from a start of charging to an end of charging of the battery, can be regarded as zero.

6. A state-of-charge detecting method for estimating a state of charge indicating an electrical quantity stored in a battery, **characterized in that** a relative value of an electrical quantity stored in the battery at any time point is detected as the state of charge, wherein the electrical quantity stored in the battery at a time point when the fully charged state is detected by using the fully charged state detecting method according to claim 5 is set to be 100%, while the electrical quantity stored in the battery at an end of discharging is set to be 0%.

7. A degradation degree detecting method for estimating a degradation degree of a battery, **characterized in that** a relative value of an electrical quantity stored in the battery at a time point when the fully charged state is detected by using the fully charged state detecting method according to claim 5 is detected as a degradation degree, wherein the electrical quantity stored in a brand-new battery in its fully charged state is set to be 100%, while the electrical quantity stored in the battery at an end of discharging is set to be 0%.

FIG. 1

FIG. 2

EP 1 610 140 A1

$E_o$   $Rpo$   $Rpolo$

$I_{CHG}$

$V_T$

$R_o = Rpo + Rpolo$

# F I G.  3

$E_o$   $R_{EO}$   $Rp'$   $Rpol'$

$I_{CHG}$

$V_T$

$R' = R_{EO} + Rp' + Rpol'$

# F I G.  4

$E_o$   $R_{LOSS}$   $R_{EO}$   $Rp'$   $Rpol'$

$I_{CHG}$

$V_T$

$R' = R_{EO} + Rp' + Rpol' + R_{LOSS}$

# F I G.  5

13

F I G. 6

CHARGING PROCESS

S 1
$E_0 \leftarrow OCV_n$

S 2
CHARGING START

S 3
OBTAINING $V$, $I_{CHG}$

S 4
INCREASE ? — Y / N

S 5
$I_{CHG0} \leftarrow I_{CHG}$
$V_T \leftarrow V$

S 6
$R_0 \leftarrow (V_T - E_0) / I_{CHG0}$

S 7
OBTAINING $I_{CHG}$

S 8
$I_{CHG}' \leftarrow I_{CHG}$

S 9
$R' \leftarrow (V_T - E_0) / I_{CHG}'$

S 10
COMPUTING CHARGING EFFICIENCY

S 11
CHARGING EFFICIENCY = 0 ? — N / Y

S 12
CHARGING END

S 13
$OCVf' \leftarrow OCV_n$

S 14
DETECTING DEGRADATION DEGREE

END

F I G. 7

<table>
<tr><td colspan="2" align="center">**INTERNATIONAL SEARCH REPORT**</td><td>International application No.<br>PCT/JP2004/004651</td></tr>
</table>

A. CLASSIFICATION OF SUBJECT MATTER
Int.Cl$^7$ G01R31/36

According to International Patent Classification (IPC) or to both national classification and IPC

B. FIELDS SEARCHED

Minimum documentation searched (classification system followed by classification symbols)
Int.Cl$^7$ G01R31/36

Documentation searched other than minimum documentation to the extent that such documents are included in the fields searched
Jitsuyo Shinan Koho         1922–1996   Jitsuyo Shinan Toroku Koho   1996–2004
Kokai Jitsuyo Shinan Koho   1971–2004   Toroku Jitsuyo Shinan Koho   1994–2004

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | JP 7-198808 A  (Honda Motor Co., Ltd.),<br>01 August, 1995 (01.08.95),<br>Full text; all drawings<br>& US 5612608 A | 1,3-7<br>2 |
| Y<br>A | JP 9-98504 A  (Mitsubishi Motors Corp.),<br>08 April, 1997 (08.04.97),<br>Full text; all drawings<br>(Family: none) | 1,3-7<br>2 |
| Y<br>A | JP 6-281711 A  (Nippon Soken, Inc.),<br>07 October, 1994 (07.10.94),<br>Full text; all drawings<br>(Family: none) | 1,3-7<br>2 |

| ☒ Further documents are listed in the continuation of Box C. | ☐ See patent family annex. |
|---|---|

```
*      Special categories of cited documents:
"A"    document defining the general state of the art which is not considered
       to be of particular relevance
"E"    earlier application or patent but published on or after the international
       filing date
"L"    document which may throw doubts on priority claim(s) or which is
       cited to establish the publication date of another citation or other
       special reason (as specified)
"O"    document referring to an oral disclosure, use, exhibition or other means
"P"    document published prior to the international filing date but later than
       the priority date claimed
```
```
"T"    later document published after the international filing date or priority
       date and not in conflict with the application but cited to understand
       the principle or theory underlying the invention
"X"    document of particular relevance; the claimed invention cannot be
       considered novel or cannot be considered to involve an inventive
       step when the document is taken alone
"Y"    document of particular relevance; the claimed invention cannot be
       considered to involve an inventive step when the document is
       combined with one or more other such documents, such combination
       being obvious to a person skilled in the art
"&"    document member of the same patent family
```

| Date of the actual completion of the international search<br>11 June, 2004 (11.06.04) | Date of mailing of the international search report<br>06 July, 2004 (06.07.04) |
|---|---|
| Name and mailing address of the ISA/<br>Japanese Patent Office | Authorized officer |
| Facsimile No. | Telephone No. |

Form PCT/ISA/210 (second sheet) (January 2004)

**INTERNATIONAL SEARCH REPORT**

| International application No. |
| --- |
| PCT/JP2004/004651 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | JP 5-284607 A (Toyota Motor Corp.), 29 October, 1993 (29.10.93), Full text; all drawings (Family: none) | 4,7 |

Form PCT/ISA/210 (continuation of second sheet) (January 2004)